# EUROPÄISCHE PATENTANMELDUNG

(11) **EP 0 833 384 A2**
(43) Veröffentlichungstag der Anmeldung: **01.04.1998**
(21) Anmeldenummer: 97116090.8
(22) Anmeldetag: 16.09.1997
(51) Int. Cl.: H01L 23/492, H01L 21/60

(54) **Halbleiterkörper mit Lotmaterialschicht**

(30) Priorität: 25.09.1996 DE 19639438
(71) Anmelder: SIEMENS AKTIENGESELLSCHAFT, 80333 München (DE)
(72) Erfinder: Hübner, Holger, Dr., 85598 Baldham (DE); Schneegans, Manfred, Dr., 85591 Vaterstetten (DE)

(57) **Zusammenfassung**

Es wird ein Metallschichtsystem zur Verlötung von Leistungshalbleitern mit Kühlkörpern vorgestellt, bei dem gegenüber den bekannten vier Metallschichtsystemen auf zwei Metallschichten verzichtet werden kann. Dabei wird auf die Halbleiterkörperrückseite (3) eine Chromschicht (4) aufgesputtert und auf die Chromschicht (4) eine Zinnschicht (5) aufgedampft. Danach wird der Halbleiterkörper (1) mit der metallenen Trägerplatte (2) durch Erwärmen auf Temperaturen oberhalb 250°C unmittelbar, d.h. ohne weitere Zusätze, verlötet.

## Beschreibung

Die Erfindung bezieht sich auf ein aus Silizium bestehenden Halbleiterkörper, der mit einer metallenen Trägerplatte über eine Folge von Metallschichten verlötbar ist.

Solche Halbleiterkörper sind in Halbleiterbauelemente, insbesondere in Leistungs-Halbleiterbauelemente, eingebaut, die sich in großer Zahl am Markt befinden. Die Folge von Metallschichten enthält in der Regel eine Aluminiumschicht, die auf einem Silizium-Halbleiterkörper sitzt. Die Aluminiumschicht haftet gut auf Silizium und bildet insbesondere mit p-dotiertem Silizium einen einwandfreien ohmschen Kontakt. Auf der Aluminiumschicht sitzt nach dem Stand der Technik eine Diffusionssperrschicht, die zumeist aus Titan oder Chrom besteht und als Haftvermittler und Rückseitenbarriere zwischen einer auf der Diffusionssperrschicht sitzenden Nickelschicht und der Aluminiumschicht dient. Auf der Nickelschicht wird nach dem Stand der Technik direkt oder auf eine darauffolgende dünne Titanschicht, die zur Haftungsverbesserung dient, eine Edelmetallschicht aufgebracht, die zumeist aus Silber, Gold oder Palladium besteht und als Oxidationsschutz für die Nickelschicht dient.

Aus der DE 19 606 101 ist bekannt, auf die Diffusionssperrschicht eine Lotmaterialschicht aufzubringen. Dort wird der Halbleiterkörper dann typischerweise auf die metallene Trägerplatte aufgelötet, in dem dieser auf die Trägerplatte aufgebracht wird und durch Erwärmen auf Temperaturen oberhalb von etwa 250°C unmittelbar, d.h. ohne Zufügen von weiteren Lötmitteln und Flußmitteln, mit der Trägerplatte verlötet wird.

Nachteilig an diesem Verfahren und an diesem Metallsystem ist, daß zumindest eine Diffusionssperrschicht, eine Haftschicht und eine Lotschicht verwendet werden muß, um eine brauchbare und feste Lötverbindung zwischen der metallenen Trägerplatte und dem Halbleiterkörper herzustellen.

Aus der DE 19 606 101 ist insbesondere ein um zwei Schichten vereinfachtes Metallsystem bekannt, bei dem insbesondere eine ca. 1 µm dicke Nickelschicht eingespart wird, was zu einer wesentlichen Verringerung der Spannung im Metallsystem und damit der Waferbiegungen führt. Auf die Nickelschicht kann dort verzichtet werden, weil als Lötverfahren das Verfahren der 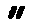 Isothermen Erstarrung" angewandt wird, bei dem die Lotschicht so dünn ist, d.h. ca. 3 µm, daß sie vollständig zu intermetallischen Phasen umgewandelt wird. Dadurch wird das Einlegieren von Lot, insbesondere von Zinn, in die Nachbarschicht begrenzt. Der elektrische Anschluß an den Silizium-Halbleiterkörper wird nach wie vor mit einer Aluminiumschicht erreicht, wobei sich an der Grenzfläche Aluminiumsilizid bildet.

Aufgabe der vorliegenden Erfindung ist es daher, einen Silizium-Halbleiterkörper derart zu metallisieren, daß die Zahl der erforderlichen Metallschichten noch weiter reduziert wird unter Beibehaltung der geringen Waferverbiegungen ohne dabei Einbußen in der Haftfestigkeit auf den Trägermaterialien zu erleiden.

Diese Aufgabe wird dadurch gelöst, daß auf die Halbleiterkörperrückseite eine Chromschicht aufgebracht ist und auf die Chromschicht eine Zinnschicht aufgebracht ist.

Ein solcher Halbleiterkörper wird dann typischerweise auf die metallene Trägerplatte aufgelötet, in dem dieser auf die Trägerplatte aufgebracht wird und durch Erwärmen auf Temperaturen oberhalb von 250°C unmittelbar, d.h. ohne Zufügen von weiteren Lötmitteln und Flußmitteln mit der Trägerplatte verlötet wird.

Typischerweise wird die Chromschicht auf die Halbleiterrückseite aufgesputtert und auf die aufgesputterte Chromschicht wird die Zinnschicht aufgedampft. Das Metallsystem reduziert sich damit auf die beiden Schichten Chrom und Zinn.

Chrom und Zinn bilden beim Erwärmen bis über den Schmelzpunkt des Zinns die metastabile intermetallische Phase Cr₂Sn₃. Diese Phase wurde erste 1964 entdeckt und ist aus L. Hollan, P. Lecoq, A. Michel, Préparation d'un composé défini Cr₂Sn₃ à partir d'un amalgame de chrome et d'étain, C.R.
Acad.Sc.Paris, 258 (1964) 3309, bekannt und beschrieben. Sie ist stabil bis 438°C. Sie bildet sich aber nur, wenn man Chrom und Zinn unterhalb dieser kritischen Temperatur miteinander reagieren läßt. Die Phase ist nicht erhältlich durch Abkühlen einer Schmelze, die eine Temperatur von über 438°C aufweist.

Durch diese neue Vorgehensweise werden nahezu spannungsfreie Lotschichten erzeugt, die zu Substratverbiegungen von weniger als 300 µm führen. Ferner ist die Haftfestigkeit der gelöteten Halbleiterkörper auf den Trägerplatten sehr hoch, d.h. in Bereichen von > 30 MPa. Proben überstanden 500 Temperaturschockzyklen von -45°C bis 120°C. Des weiteren ist die an der Grenzfläche zwischen Silizium-Halbleiterkörper und Chromschicht existierende Chromsilizid-Schicht, die als Diffusionsbarriere wirkt, durch Auger-Tiefenprofilanalysen nachgewiesen. Auch nach Tempern bis 400°C wurde im Silizium kein Zinn gefunden.

Darüber hinaus kann mit den erfindungsgemäß metallisierten Halbleiterkörpern und dem erfindungsgemäßen Verfahren eine deutliche Kostenreduzierung erzielt werden, da die Materialkosten, insbesondere durch das Wegfallen einer Oxidationsschutzschicht, gesenkt und der Durchsatz erhöht werden können. Ferner ist das erfindungsgemäße Verfahren auch besonders umweltfreundlich, da durch die Flußmittelfreiheit Reinigungsschritte mit FCKW-Lösemitteln entfallen.

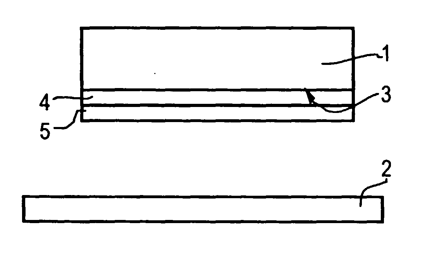

In der Figur ist die Schichtfolge der Metalle vor dem Verlöten gezeigt. Gemäß der Erfindung ist auf der Halbleitekörperrückseite 3 eine Chromschicht 4 durch Sputtern aufgebracht, die auf Silizium gut haftet und insbesondere mit p-dotiertem Silizium einen einwandfreien ohmschen Kontakt bildet. Auf der Chromschicht 4 sitzt eine Zinnschicht 5, die als Lotschicht dient und im wesentlichen eine Dicke von ca. 50 nm aufweist. Diese Zinnschicht 5 wird auf die Chromschicht 4 gesputtert. Die Zinnschicht 5 weist typischerweise eine Dicke von ungefähr 2700 nm auf. Der so metallisierte Silizium-Halbleiterkörper 1 wird dann auf die metallene Trägerplatte 2 gedrückt, die in der Regel aus Kupfer besteht, und bei ungefähr 300°C unter einer Schutzgasatmosphäre oder unter Vakuumbedingungen mit dieser verbunden, wobei eine metallurgische Verbindung, die Cr₃Sn₃-Phase zwischen der Chromschicht 4 und der Zinnschicht 5, entsteht, die bis zu einer Temperatur von 438°C stabil ist.

Bei Anwendung des erfindungsgemäßen Verfahrens wird ein Produkt von hoher Qualität erzeugt, da die beschriebene Schichtenfolge einen besonders guten mechanischen und elektrisch stabilen Kontakt ergibt. Insbesondere ist das Verfahren sowohl unter technologischen als auch ökonomischen und ökologischen Gesichtspunkten als sehr vorteilhaft zu bezeichnen.

Technologisch wird durch das erfindungsgemäße Verfahren und die erfindungsgemäße Metallisierung die Möglichkeit eröffnet, die Dicken der Silizium-Halbleitersubstrate weiter zu verringern, was zur Verbesserung der Durchlaßeigenschaft bei Leistungs-Halbleiterbauelementen führt. Ökonomisch liegen die Vorteile darin, daß die Materialkosten reduziert werden können und der Durchsatz in der Fertigung erhöht werden kann.

## Patentansprüche

1. Aus Silizium bestehender Halbleiterkörper (1) der mit einer metallenen Trägerplatte (2) über eine Folge von Metallschichten verlötbar ist,
**dadurch gekennzeichnet,** daß auf die Halbleiterkörperrückseite (3) eine Chromschicht (4) aufgebracht ist und auf die Chromschicht (4) eine Zinnschicht (5) aufgebracht ist.

2. Halbleiterkörper nach Anspruch 1,
**dadurch gekennzeichnet,** daß die Chromschicht (4) aufgesputtert ist und die Zinnschicht (5) aufgedampft ist.

3. Halbleiterkörper nach einem der Ansprüche 1 oder 2,
**gekennzeichnet durch** eine Dicke der Chromschicht (4) von etwa 50 nm.

4. Halbleiterkörper nach einem der Ansprüche 1 bis 3,
**gekennzeichnet durch** eine Dicke der Zinnschicht von weniger als 3000 nm.

5. Verfahren zum Auflöten eines Halbleiterkörpers (1) nach einem der Ansprüche 1 bis 4 auf eine metallene Trägerplatte (2),
**dadurch gekennzeichnet,** daß der Halbleiterkörper (1) auf die Trägerplatte (2) aufgebracht wird und durch Erwärmen auf Temperaturen oberhalb von etwa 250°C unmittelbar mit der Trägerplatte (2) verlötet wird.
